# EUROPEAN PATENT APPLICATION

(11) **EP 1 091 385 A1**
(43) Date of publication of application: **11.04.2001**
(21) Application number: 99119096.8
(22) Date of filing: 04.10.1999
(51) Int. Cl.: H01J 37/304, H01J 37/317

(54) **Electron-beam lithography system and alignment method**

(71) Applicant: Advantest Corporation, Nerima-ku, Tokyo 179-0071 (JP)
(72) Inventor: Ichikawa, Natsume, Nerima-ku, Tokyo 179-0071 (JP); Kawakami, Kenichi, Nerima-ku, Tokyo 179-0071 (JP)
(74) Representative: Cohausz & Florack

(57) **Abstract**

Disclosed are an electron-beam lithography system employing an optical mark detector and having a distance of movement, by which a stage must be moved, minimized, and an alignment method. The electron-beam lithography system consists mainly of an electro-optical column, a control unit, a stage moving mechanism, a mark detector, and at least two optical mark detectors. The electro-optical column accommodates an electron beam source, a converging unit for converging en electron beam output from the electron beam source, and a deflecting unit for deflecting the electron beam. The control unit controls the converging unit and deflecting unit. The stage moving mechanism moves a stage that holds a sample to which an electron beam is irradiated. The mark detector measures electrons reflected when a position detection mark inscribed on the sample or stage is scanned with an electron beam, and detects the position of the position detection mark from a signal of detected reflected electrons. The at least two optical mark detectors optically detect the position of a position detection mark.

## Description

### BACKGROUND OF THE INVENTION

### 1. Field of the Invention

The present invention relates to an electron-beam lithography system for detecting a position detection mark used to determine an exposed position by adopting a method of measuring electrons reflected when the position detection mark is scanned with an electron beam and by employing an optical mark detector for optically detecting the position detection mark. The present invention also relates to an alignment method for determining the exposed position in the electron-beam lithography system.

### 2. Description of the Related Art

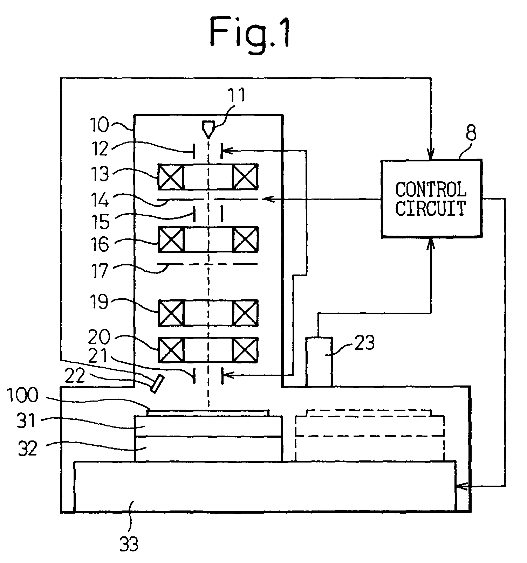

Recently, it has been pointed out that optical patterning lithography methods including step-and-repeat photolithography methods with demagnification have reached their limits. An electron-beam lithography method has drawn attention as a method capable of drawing finer patterns. Fig. 1 shows a basic configuration of an electron-beam lithography system. An electron gun 11 is a filament made of LaB₆ or the like and radiates an electron beam. An electron beam emanating from the electron gun 11 is accelerated, passed through a blanking electrode 12, and then converged on an aperture 17 by a second lens 16. At this time, a beam reshaping electrostatic deflector 15 is used to adjust the directions of electrons, whereby the electron beam is reshaped to have a predetermined shape. The reshaped electron beam is demagnified by a third lens 19, and converged to form an image on an exposed surface by a fourth lens 20. An irradiated position at which an electron beam is irradiated is determined with a magnitude of deflection made by a position specifying electrostatic deflector 21. The irradiated position of an electron beam on a sample 100 is, as described later, detected by scanning a position detection mark inscribed on a sample with the electron beam and then measuring reflected and scattered electrons using an electron detector 22. In reality, in addition to these components, pluralities of static deflectors and electromagnetic deflectors are included. Herein, the deflectors are omitted. A housing accommodating these components is referred to as an electro-optical column. Reference numeral 10 denotes the electro-optical column. A control circuit 8 controls the components incorporated in the electro-optical column.

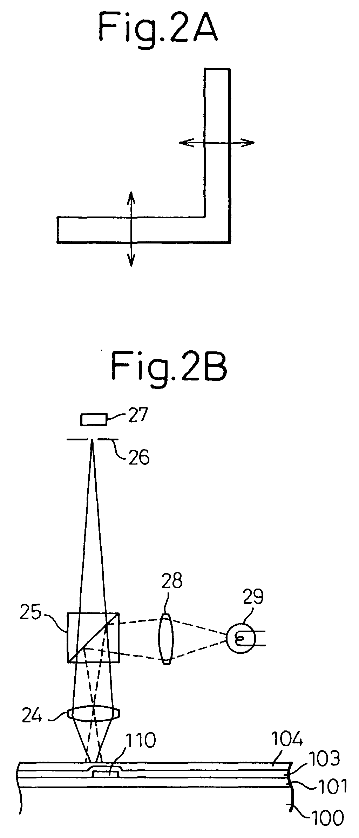

Reference numeral 23 denotes an optical mark detector for optically detecting a position detection mark. Referring to Fig. 2A and Fig. 2B, the optical mark detector 23 will be described briefly.

As mentioned above, a position detection mark (alignment mark) used to define an exposed position is inscribed for each chip on the sample 100. When the sample 100 is exposed to an electron beam, the mark is scanned with the electron beam, and reflected and scattered electrons are measured by the electron detector 22. The position of the mark is thus detected, and the exposed position is determined with the mark as a reference point. The mark is, for example, as shown in Fig. 2A, planar. The mark is scanned in X and Y directions, whereby the positions of the edges are detected. The mark is, as shown in Fig. 2B, made by laying a base thin film layer 101 on the sample 100, forming marks 110 as steps on the base thin film layer, and finally accumulating a thin film layer 103. As the thin film layer 103 is accumulated, it has stepped portions coincident with the marks 110. A resist 104 is applied to the thin film layer, and scanned with an electron beam. Reflected electrons are measured. Since the thin film layer 103 and resist 104 are mutually different in density, the reflected state of an electron beam undergoes a change at the stepped portions. This causes a reflected electron signal to vary. The surface of the applied resist 104 is not fully planar but has slightly stepped portions coincident with the marks 110. In reality, a mark is detected based on both information of a stepped portion of the resist surface and information of an interface between the resist and the thin film layer 103. By observing the variation in the reflected electron signal, the position of the stepped portion in a system of coordinates in which an electron beam is deflected, that is, the position of a mark 110 is revealed. The exposed position is determined with the position of the detected mark 110 as a reference, whereby patterns of circuits can be aligned with one another. The created marks 110 may be used in common for forming a plurality of subsequent layers. Alternatively, every time a layer is formed, marks to be used for forming the next layer may be created without fail. In other words, different marks may be used for each layer. Moreover, the marks 110 may be created on the sample 100 but not on the base thin film layer 101 or may be created on a plurality of base thin film layers 101.

Semiconductor integrated circuits are tending to be integrated at a higher density along with advances in microprocessing technology. The performance which the microprocessing technology is requested to offer has been evaluated more severely. A polishing step such as a chemical mechanical polishing (CMP) step has been adopted in order to keep the surfaces of devices flat so that exposure can be achieved successfully at each exposure step. When the CMP step is adopted to form the thin film layer 103, the stepped portions of the thin film layer coincident with the marks 110 are lowered or evened completely. This poses a problem in that it becomes impossible to detect the position of a mark using an electron beam.

The optical mark detector 23 is employed for the above reason. The optical mark detector 23 can detect a difference between a mark 110 and the thin film layer 103 through the resist 104 even if the stepped portion of the thin film layer 103 coincident with the mark 110 is evened. The optical mark detector 23 irradiates, as shown in Fig. 2B, light emanating from a light source 29 to the surface of the sample through a lens 28, a beam splitter 25, and an objective lens 24. The objective lens 24 forms an optical image of the surface of an object, that is, a mark 110 at the position of a slit 26. An optical sensor 27 is located behind the slit 26, and detects an amount of light passing through the slit 26. A stage 31 is moved so that the image of the mark 110 will pass through the slit 26. The optical sensor 27 changes accordingly, whereby the edges of the mark 110 can be detected.

The optical mark detector 23 may be of any of various types. However, whichever of the types is adopted, the optical mark detector 23 is somewhat bulky. The space between the position specifying electrostatic deflector 21 and the fourth lens 20 or sample 100 is so narrow that the optical mark detector 23 cannot be interposed between them. The optical mark detector 23 is therefore, as illustrated, located by the side of the electro-optical column 10. Whichever of the types of optical mark detectors is adopted, a mark 110 must be located immediately below the optical mark detector 23 in order to detect the mark 110 on the sample 100.

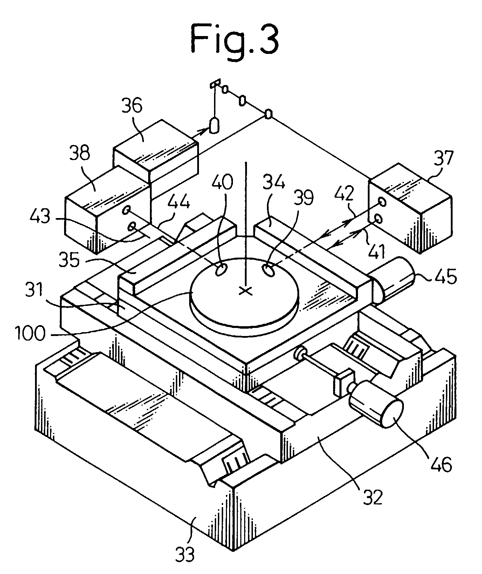

Referring back to Fig. 1, the sample 100 is placed on the stage 31. The stage 31 can be moved in the X and Y directions by a two-dimension moving mechanism. Fig. 3 shows an example of a two-dimension moving mechanism. An X-direction moving mechanism is mounted on a base 33. A DC servo motor 45 is driven in order to move an X moving station 32 in the X directions. A Y-direction moving mechanism is mounted on the X moving station 32. By driving a DC servo motor 46, the stage 31 is moved in the Y directions. The magnitude of a movement made by the stage 31 is measured by a laser interferometer. A laser beam emitted from a frequency-stabilized laser 36 is split into two beams, and input to an X-direction laser interference unit 37 and a Y-direction laser interference unit 38 which are fixed to the base 33. The laser beam incident on the X-direction laser interference unit 37 is further split into two beams and emitted. One of the laser beams 42 is reflected in an opposite direction by a reference mirror 39 fixed to the base 33 and returned to the X-direction laser interference unit 37. The other laser beam 41 is reflected in an opposite direction by a mirror 34 fixed to the stage 31 and returned to the X-direction laser interference unit 37. The two laser beams that have come back are mixed within the X-direction laser interference unit 37, whereby interference fringes are produced. When the stage 31 moves in an X direction, the position of the mirror 34 changes. Accordingly, the interference fringes undergo a change. The changes are counted in order to measure the magnitude of a movement in the X direction made by the stage 31. The same applies to the Y-direction laser interference unit 38. The stage 31 has a mirror 35. The mirror 35 reflects a laser beam 43 emitted from the Y-direction laser interference unit 38 in an opposite direction. The magnitude of a movement in a Y direction made by the stage 31 is thus measured.

The mirrors 34 and 35 must reflect the laser beams 41 and 43 emitted from the X-direction and Y-direction laser interference units 37 and 38 despite the movement of the stage 31. As illustrated, the length of the mirrors 34 and 35 must be equal to or larger than a length equivalent to a range of movements made by the stage 31.

The control unit 8 shown in Fig. 1 produces a control signal from outputs of the electronic detector 22 and optical mark detector 23 and data of patterns to be drawn, and controls the components incorporated in the electro-optical column 10 and the two-dimensional moving mechanism.

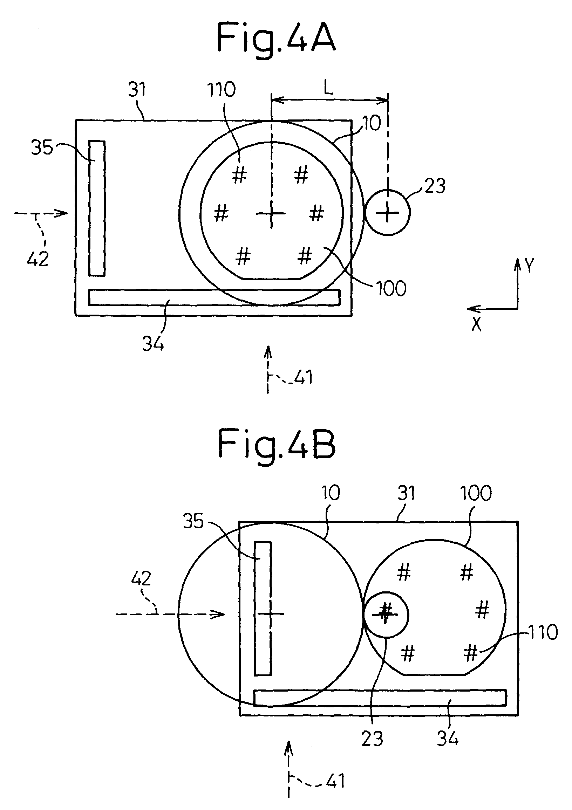

The range of movement the stage 31 must make will be discussed with reference to Fig. 4A and Fig. 4B. Fig. 4A shows a state in which the center of the electro-optical column 10 is aligned with the center of the sample 100. A range of irradiation within which an electron beam is irradiated is a narrow area around the center of the sample 100. For exposing the whole surface of the sample 100, therefore, the stage must be moved so that an exposed area of the sample 100 will lie in the center of the electro-optical column 10. For brevity's sake, the whole surface of the sample 100 shall be regarded as the exposed area. The stage must therefore be moved from the position shown in Fig. 4A by a length equivalent to the radius of the sample in opposite X and Y directions. Moreover, as mentioned above, for making it possible to detect a mark 110, the mark 110 must be located immediately below the optical mark detector 23. Assuming that the marks 110 lie around the sample 100, the stage must be moved so that the mark 110 will be located immediately below the optical mark detector 23. Fig. 4B shows a state in which the leftmost mark 110 on the sample 100 is located immediately below the optical mark detector 23.

As for the Y directions, the stage 31 must be moved both upward and downward from the position shown in Fig. 4A by the length equivalent to the radius of a sample. A distance of movement in the Y directions by which the stage must be moved is the same as the diameter of the sample 100. As for the X directions, the stage 31 must be able to be moved between the left position distanced by the length equivalent to the radius of a sample and the position shown in Fig. 4B. A distance of movement in the X directions by which the stage must be moved is the sum of the diameter of the sample 100 and a distance L between the centers of the electro-optical column 10 and optical mark detector 23. When the optical mark detector 23 is used, the distance of movement by which the stage 31 must be moved must be made longer by the distance L between the centers of the electro-optical column 10 and optical mark detector 23.

As mentioned above, the mirrors 34 and 35 reflecting a laser beam coming from the laser interferometer must have a length equal to or larger than the distance of movement by which the stage 31 must be moved. When the distance of movement in the X directions is extended, the length of the mirror 34 must be increased accordingly. Since the mirror 34 is fixed to the stage 31, the stage 31 must be made longer. This leads to an increase in the costs of the mirror 34 and stage 31. Besides, the increase in size of the stage 31 invites degradations of precision in moving the stage 31 and of performance of the mirror 34. This eventually leads to degradation of precision in detecting a distance of movement. Furthermore, since the stage 31 becomes large in size, the stage 31 becomes heavier. This results in deterioration in control efficiency.

### SUMMARY OF THE INVENTION

An object of the present invention is to realize an electron-beam lithography system employing an optical mark detector having a distance of movement, by which a stage must be moved, minimized and thus providing low cost and high-precision positioning, and to realize an alignment method to be implemented in the electron-beam lithography system.

To accomplish the above object, an electron-beam lithography system in accordance with the present invention includes a plurality of optical mark detectors. The electron-beam lithography system in accordance with the present invention consists mainly of an electro-optical column, a control unit, a stage moving mechanism, a mark detector, and optical mark detectors. The electro-optical column includes an electron beam source, a converging means for converging an electron beam output from the electron beam source, and a deflecting means for deflecting the electron beam. The control unit controls the converging means and deflecting means. The stage moving mechanism moves the stage that holds a sample to which an electron beam is irradiated. The mark detector measures electrons reflected when a position detection mark inscribed on the sample or stage is scanned with an electron beam, and thus detects the position of the position detection mark. The optical mark detectors optically detect the position of a position detection mark. Herein, at least two optical mark detectors are included in the electron-beam lithography system.

Two out of the at least two optical mark detectors should preferably be located in substantially opposite directions with respect to the center axis of the electro-optical column.

According to an alignment method of the present invention to be implemented in an electron-beam lithography system, the position of a position detection mark is detected by an optical mark detector located near the position detection mark. This contributes to a decrease in a distance over which a stage must be moved.

The positional relationship between an electro-optical column and an optical mark detector is measured using a mark detectable by both of them. The relative positional relationships among a plurality of optical mark detectors are calculated from the positional relationships between the optical mark detectors and the electro-optical column. Marks used to measure a positional relationship need not be inscribed on a sample but may be inscribed on a stage. Once the positional relationship is measured, a position detection mark on the sample need not be detected by scanning it with an electron beam. An exposed position can be determined based on a position detected by one optical mark detector. However, since the distance between the electro-optical column and each optical mark detector varies with a change in temperature, the exposed position should preferably be calibrated if necessary.

If a sample is large, the distance between the optical mark detectors located on both sides of the electro-optical column may be smaller than the diameter of the sample. In this case, a distance of movement by which the stage must be moved is equivalent to the size of the sample. Despite the presence of the optical mark detectors, the distance of movement need not be extended. Moreover, the plurality of optical mark detectors can detect a position detection mark concurrently. In this case, a plurality of position detection marks is detected substantially concurrently using at least two optical mark detectors. This contributes to a decrease in the time required for alignment.

A change in the positional relationship between a base of a system, to which a stage moving mechanism is fixed, and the electro-optical column caused by vibrations or temperature is measured and corrected. For this purpose, the positional relationship of the electro-optical column to the base of the system is measured using a laser interferometer or the like. Preferably, the positional relationships of the plurality of optical mark detectors to the base should be measured similarly.

### BRIEF DESCRIPTION OF THE DRAWINGS

Fig. 1 shows the basic configuration of a conventional electron-beam lithography system;
Fig. 2A shows the shape of a position detection mark;
Fig. 2B shows an example of configurations of an optical mark detector;
Fig. 3 shows a two-dimensional moving mechanism employed in an electron-beam lithography system or the like;
Fig. 4A and Fig. 4B are explanatory diagrams concerning a distance of movement by which a stage must be moved in accordance with a related art;
Fig. 5 shows the positional relationship among components of an electron-beam lithography system in accordance with the first embodiment of the present invention;
Fig. 6A and Fig. 6B are explanatory diagrams concerning a distance of movement by which a stage must be moved in accordance with the first embodiment;
Fig. 7 shows the positional relationship among components of an electron-beam lithography system in accordance with the second embodiment of the present invention;
Fig. 8A and Fig. 8B are explanatory diagrams concerning a scene where any of position detection marks is detected in accordance with the second embodiment; and
Fig. 9 shows the positional relationship among components of an electron-beam lithography system in accordance with the third embodiment of the present invention.

### DESCRIPTION OF THE PREFERRED EMBODIMENTS

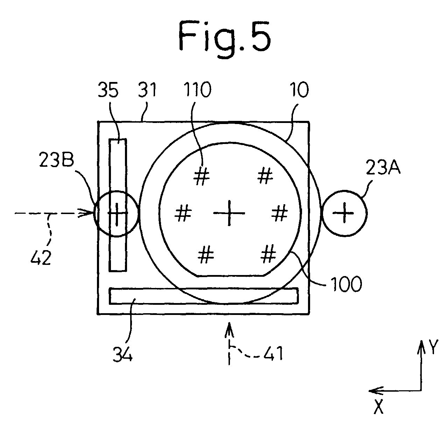

Fig. 5 shows the relationship between components of an electron-beam lithography system in accordance with the first embodiment of the present invention. As illustrated, the first embodiment is different from the related art in a point that two optical mark detectors 23A and 23B are included. The other components are identical to those of the related art shown in Fig. 1 to Fig. 3.

In the electron-beam lithography system of the first embodiment, the two optical mark detectors 23A and 23B are located in opposite directions with respect to the center axis of an electro-optical column 10. Assuming that the distance between the centers of the electro-optical column 10 and the optical mark detector 23A or 23B is L, the distance between the centers of the optical mark detectors 23A and 23B is 2L.

A range of movement in the Y direction within which a stage 31 included in the electron-beam lithography system of the first embodiment must be moved is the same as that of the related art. The center axis of the electro-optical column 10 and the centers of the two optical mark detectors 23A and 23B must be able to be moved between the upper and lower edges of a sample 100. In other words, the electro-optical column 10 and the two optical mark detectors 23A and 23B must be able to be moved by a distance equivalent to the diameter of the sample 100 or longer. The length of a mirror 35 is therefore equal to or larger than the diameter of the sample 100.

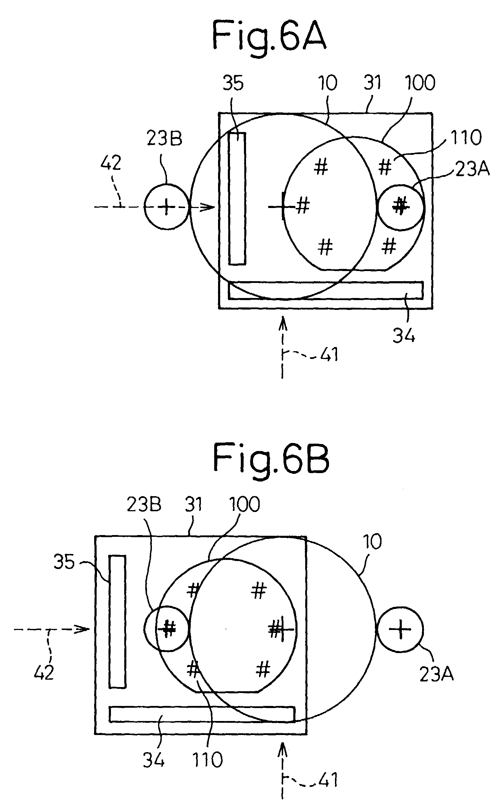

A range of movement in the X direction within which the stage must be moved will be described with reference to Fig. 6A and Fig. 6B. Fig. 6A shows a state in which the right optical mark detector 23A is located immediately above a right position detection mark 110 on the sample 100. Fig. 6B shows a state in which the left optical mark detector 23B is located immediately above a left position detection mark 110 on the sample 100. In the first embodiment, position detection marks 110 located on the right-hand side of the sample relative to the center thereof are detected using the right optical mark detector 23A. Position detection marks 110 located on the left-hand side of the sample relative to the center thereof are detected using the left optical mark detector 23B. When the center of the sample 100 is located immediately below the right optical mark detector 23A, the stage 31 has been moved to the extreme right. When the center of the sample 100 is located immediately below the left optical mark detector 23B, the stage 31 has been moved to the extreme left. For attaining the states, the stage 31 must be moved from the position shown in Fig. 5 to the right and left respectively by the distance L. A distance of movement in X directions by which the stage must be moved is therefore 2L.

As mentioned above, when one optical mark detector is employed, the distance in the X direction by which the stage must be moved is the sum of the diameter of the sample 100 and the distance L between the electro-optical column 10 and optical mark detector. If L is smaller than the diameter of the sample 100, the distance of movement can be made smaller than that in the related art. As far as existing electron-beam lithography systems are concerned, generally, L is smaller than the diameter of the sample 100. When the present invention is implemented, the movement by which the stage 31 must be moved can be diminished. Consequently, the length of the mirror 34 can be shortened.

When alignment is performed in the electron-beam lithography system of the first embodiment, calibration is carried out first. For calibration, a reference sample (wafer) 100 having marks 110 formed thereon is employed. The marks 110 are detectable either when scanned with an electron beam or by employing the optical mark detectors 23A and 23B. One or more marks 110 are formed in the left half of the reference sample 100 and the right half thereof alike. The reference sample 110 is placed on the stage 31. A mark 110 is scanned with an electron beam, whereby the positional relationship of the electro-optical column 10 on the system of coordinates defined for the moving mechanism is measured. Thereafter, a mark 110 located in the right half of the reference sample is detected using the optical mark detector 23A. The positional relationship of the optical mark detector 23A on the system of coordinates defined for the moving mechanism is measured. Similarly, a mark 110 located in the left half of the reference sample is detected using the optical mark detector 23B in order to measure the positional relationship of the optical mark detector 23B on the system of coordinates defined for the moving mechanism. Based on the positional relationships, the positional relationships between the electro-optical column 10 and the optical mark detectors 23A and 23B are calculated. Consequently, the positional relationship between the two optical mark detectors 23A and 23B is calculated.

When calibration is completed, exposure is carried out. It is impossible to detect a position detection mark 110 inscribed on a sample to be exposed by scanning it with an electron beam. For detecting a position detection mark 110 located in the right half of the sample, the position detection mark is positioned immediately below the right optical mark detector 23A so that it can be detected. The stage 31 is moved by a distance calculated from the detected position of the mark 110 and the positional relationships calculated through calibration. Consequently, a desired position on the sample can be exposed to an electron beam. The same applies to the other position detection marks. For detecting a position detection mark 110 located in the left half of the sample, the left optical mark detector 23B is employed. Even after calibration is carried out once, the positional relationships may vary depending on a change in temperature or the like. In this case, the reference sample is used instead of a sample in order to carry out calibration.

Moreover, the positional relationship between the base of the system to which the stage moving mechanism is fixed and the electro-optical column changes with vibrations or depending on temperature. A change in the positional relationship of the electro-optical column to the base of the system is measured all the time using a laser interferometer. An exposure position is thus corrected. The positional relationship of the optical mark detector to the base thereof may also change. The change in the positional relationship should therefore preferably be measured using the laser interferometer. Preferably, values used to align patterns should be corrected based on the results of detection.

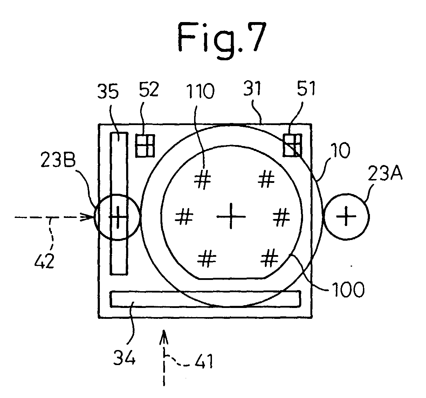

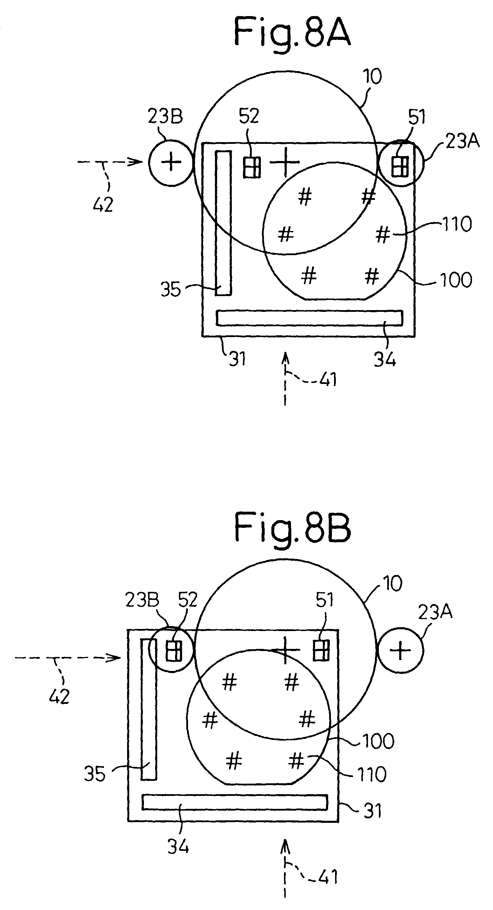

Fig. 7 shows the relationship among arranged components of an electron-beam lithography system in accordance with the second embodiment of the present invention. As illustrated, the second embodiment is different from the first embodiment in a point that position detection marks for calibration 51 and 52 are inscribed on the stage 31. For calibration, the right position detection mark 51 is scanned with an electron beam in order to detect a position. Meanwhile, as shown in Fig. 8A, the position detection mark 51 is detected by the right optical mark detector 23A in order to measure the positional relationship between the electro-optical column and the right optical mark detector 23A. Thereafter, the position of the left position detection mark 52 is detected by scanning it with an electron beam. Meanwhile, as shown in Fig. 8B, the position detection mark 52 is detected by the left optical mark detector 23B in order to measure the positional relationship between the electro-optical column and the left optical mark detector 23B. The other components are identical to those of the first embodiment.

In the first embodiment, a reference sample is used for calibration. Every time calibration is carried out, a sample must be replaced with the reference sample. In contrast, according to the second embodiment, calibration can be carried out with the sample 100 to be exposed placed on the stage 31. Calibration can therefore be carried out readily, if necessary, even during exposure.

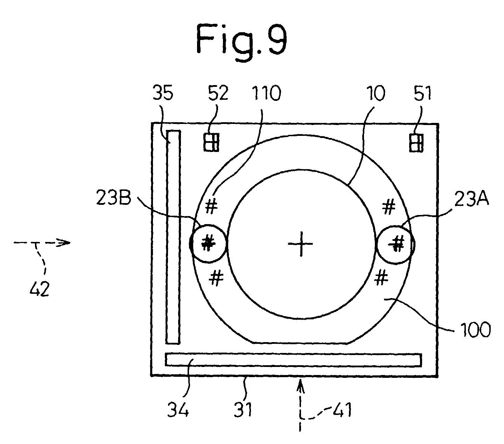

Fig. 9 shows the relationship between components of an electron-beam lithography system in accordance with the third embodiment of the present invention. As illustrated, the third embodiment is different from the second embodiment in the point that the diameter of the sample (wafer) 100 is larger by the distance 2L between the two optical mark detectors 23A and 23B. In this case, two marks 110 on the sample 100 may be located near the optical mark detectors 23A and 23B respectively. In this case, one of the marks, is detected using one of the optical mark detectors. Immediately thereafter, the other mark is detected using the other optical mark detector. In this case, the magnitude of movement by which the stage must be moved is limited so that the time required for detecting a mark can be shortened.

As described so far, according to the present invention, there is provided an electron-beam lithography system in which a position detection mark is detected using an optical detector. Since the movement by which a stage must be moved can be reduced, the cost of a mirror and of a stage used to detect the magnitude of a movement can be minimized, and the stage can be designed compactly. Consequently, precision in moving the stage or precision in measuring the distance of movement can be improved. Furthermore, the efficiency in controlling the stage 31 can be improved.

## Claims

1. An electron-beam lithography system, comprising:
an electro-optical column accommodating an electron beam source, a converging means for converging an electron beam output from said electron beam source, and a deflecting means for deflecting the electron beam;
a control unit for controlling said converging means and deflecting means;
a stage moving mechanism for moving a stage that holds a sample to which an electron beam is irradiated;
a mark detector for measuring electrons reflected when a position detection mark inscribed on said sample or stage is scanned with an electron beam, and detecting the position of the position detection mark from a signal of detected reflected electrons; and
optical mark detectors for optically detecting the position of a position detection mark,
wherein at least two optical mark detectors are included.

2. An electron-beam lithography system according to claim 1, wherein two out of said at least two optical mark detectors are arranged in substantially opposite directions with respect to the center axis of said electro-optical column.

3. An electron-beam lithography system according to claim 1, further comprising a displacement measuring mechanism for measuring a positional change between each optical mark detector and a base of said electron-beam lithography system.

4. An electron-beam lithography system according to claim 3, wherein said displacement measuring mechanism is a laser interferometer, and wherein each optical mark detector includes a reflector for reflecting laser light emitted from a laser interference unit incorporated in said base of said electron-beam lithography system, and thus returning the laser light to said laser interference unit.

5. An alignment method to be implemented in an electron-beam lithography system set forth in any of claims 1 to 4, wherein the position of a position detection mark is detected using said optical mark detector located near the position detection mark.

6. An alignment method according to claim 5, wherein for detecting a position detection mark using said optical mark detector, the position detection mark is positioned immediately below said optical mark detector, and wherein the positions of a plurality of position detection marks are detected substantially concurrently using said at least two optical mark detectors.
